# EUROPEAN PATENT APPLICATION

(11) **EP 4 678 314 A1**
(43) Date of publication of application: **14.01.2026**
(21) Application number: 24766686.0
(22) Date of filing: 19.01.2024
(51) Int. Cl.: B23B 27/14, C23C 14/06, C23C 14/32

(54) **COATED CUTTING TOOL**

(30) Priority: 06.03.2023 JP 2023033459
(71) Applicant: MOLDINO Tool Engineering, Ltd., Tokyo 130-0026 (JP)
(72) Inventor: FUWA Ryotaro, Yasu-shi, Shiga 520-2323 (JP); OHNO Satoshi, Narita-shi, Chiba 286-0825 (JP)
(74) Representative: Gille Hrabal Partnerschaftsgesellschaft mbB Patentanwälte
(86) International application number: PCT/JP2024/001452
(87) International publication number: WO 2024/185311

(57) **Abstract**

A coated cutting tool includes a lower layer, a middle layer, and an upper layer. The lower layer comprises a composition AlₐCr_{b}ML_{1-a-b}N (ML is at least one element selected from the group consisting of Ti, Zr, Hf, V, Nb, Ta, Mo, and W, 0.60≤a≤0.70, and 0.30≤b≤0.40). The middle layer comprises first sublayers and second sublayers alternately deposited. The first sublayers each comprises a composition Al_{c}Ti_{d}M1_{1-c-d}N (M1 is at least one element selected from the group consisting of Zr, Hf, V, Nb, Ta, Mo, and W, 0.50≤c≤0.55, and 0.45≤d≤0.50). The second sublayers each comprises a composition AlₑCr_{f}M2_{1-e-f}N (M2 is at least one element selected from the group of Ti, Zr, Hf, V, Nb, Ta, Mo, and W, 0.60≤e≤0.70, and 0.30≤f≤0.40). The upper layer comprises a composition Al_{g}CrₕMU_{1-g-h}N (MU is at least one selected from the group consisting of Ti, Zr, Hf, V, Nb, Ta, Mo, and W, 0.60≤g≤0.70, and 0.30≤h≤0.40).

## Description

### Technical Field

The present invention relates to coated cutting tools. This application claims priority based on Japanese Patent Application No. 2023-33459 filed on March 6, 2023. The entire description in the Japanese patent application is hereby incorporated by reference.

### Background Art

Coated cutting tools with coating layers vapor-deposited on a substrate made of, for example, tungsten carbide (hereafter denoted as WC) have been used. These coated cutting tools exhibit enhanced durability. In order to further enhance the durability of these coated cutting tools, various proposals have been made concerning the composition and configuration of the coating layers.

For example, Patent Literature 1 discloses a coated cutting tool with a coated layer consisting of an AlCr composite nitride layer deposited on an AiTi composite nitride layer on a substrate. The coated cutting tool has reduced residual stress while maintaining high hardness of the coated layer and has high adhesion strength between the two deposited layers, resulting in a prolonged service life.

### Citation List

### Patent Literature

PTL 1: Japanese Patent Application Unexamined Publication No. 2010-12564

### Summary of Invention

### Technical Problem

An object of the present invention, which was made in view of the aforementioned circumstances and proposal, is to provide a coated cutting tool with excellent durability even when the tool is used for cutting work of work materials made of steel (alloy steel) within a hardness range from mild steel to material with about 40 HRC.

### Solution to Problem

A coated cutting tool in accordance with an embodiment of the present invention comprises:
a substrate and a coating segment disposed on the substrate;
the coating segment including a lower layer, a middle layer on the lower layer, and an upper layer on the middle layer;
the lower layer comprising composite nitride comprising crystal grains having a face-centered cubic lattice structure and having an average composition represented by AlₐCr_{b}ML_{1-a-b}N where ML is at least one element selected from the group consisting of Ti, Zr, Hf, V, Nb, Ta, Mo, and W, 0.60 ≤ a ≤ 0.70, and 0.30 ≤ b ≤ 0.40);
the middle layer comprising an alternating laminate of first sublayers and second sublayers, both sublayers having an average thickness in a range of 5 nm to 100 nm and comprising crystal grains with a face-centered cubic lattice structure;
   the first sublayers each comprising composite nitride having an average composition represented by Al_{c}Ti_{d}M1_{1-c-d}N where M1 is at least one element selected from the group consisting of Zr, Hf, V, Nb, Ta, Mo, and W, 0.50 ≤ c ≤ 0.55, and 0.45 ≤ d ≤ 0.50;
   the second sublayers each comprising composite nitride having an average composition represented by AlₑCr_{f}M2_{1-e-f}N where M2 is at least one element selected from the group of Ti, Zr, Hf, V, Nb, Ta, Mo, and W, 0.60 ≤ e ≤ 0.70, and 0.30 ≤ f ≤ 0.40;
the upper layer comprising composite nitride comprising crystal grains having a face-centered cubic lattice structure and an average composition represented by Al_{g}CrₕMU_{1-g-h}N where MU is at least one selected from the group consisting of Ti, Zr, Hf, V, Nb, Ta, Mo, and W, 0.60 ≤ g ≤ 0.70, and 0.30 ≤ h ≤ 0.40.

The coated cutting tools of the embodiment may satisfy the following item (1):
(1) The sum of the average thicknesses of the lower, middle and upper layers ranges from 3.5 µm to 6.0 µm.

### Advantageous Effects of Invention

The coated cutting tool has high durability when used in cutting operations of work materials made of steel (alloy steel) with a hardness ranging from mild steel to 40 HRC.

### Brief Description of Drawings

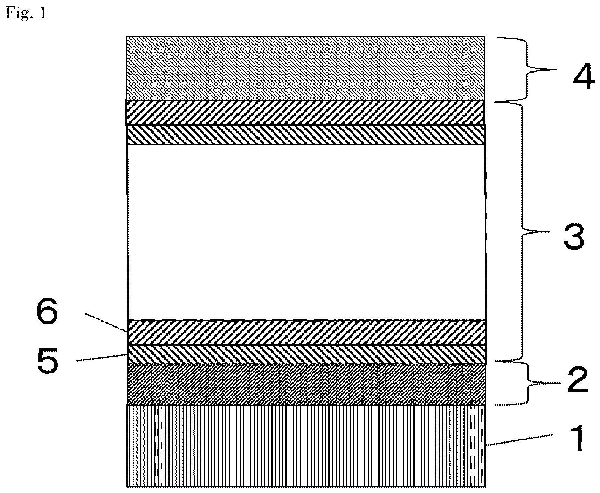

Fig. 1 is a schematic diagram illustrating an exemplary longitudinal section of a coated cutting tool.

### Description of Embodiment

The inventor has made an intensive study of coated cutting tools with high durability in cutting operations, in particular in milling operations, of work materials made of steel (alloy steel) with a hardness ranging from mild steel to about 40 HRC.

As a result, the inventor has recognized that the durability of the coating segment including a nitride layer containing AlCr simply deposited on a composite nitride layer containing AlTi, can be further improved.

In detail, it was found that the durability of the coating segment is further improved if the alternating laminate of AlTi-containing composite nitride layers and AlCr-containing composite nitride layers, both of which have a predetermined average thickness, are disposed between Al-rich AlCr-containing composite nitride layers.

The coated cutting tools of the embodiments of the present invention will now be described in more detail. When a numerical range is expressed as "L to M" throughout the specification and in the claims, this expression is synonymous with "L or more and M or less", and the range includes the upper limit (M) and the lower limit (L). When unit is stated only for the upper limit (M), the upper limit (M) and the lower limit (L) are in the same unit. In addition, each value includes experimental errors.

The coated cutting tools of the present invention will now be described.

### 1. Coating segment

Fig. 1 schematically shows an exemplary longitudinal section (a section perpendicular to the surface of the substrate, assuming no micro-unevenness of the surface of the substrate) of the coating segment of the coated cutting tool of an embodiment of the invention. As can be seen from Fig. 1, the coating segment is formed on the substrate (1) and includes a lower layer (2), a middle layer (3) and an upper layer (4), in order from the substrate (1) towards the surface of the coated cutting tool. The middle layer (3) includes an alternating laminate of first sublayers (5) and second sublayers (6). In Figure 1, the white area of the middle layer (3) also includes alternating first sublayers (5) and second sublayers (6).

### (1) Average thickness of coating segment

The average thickness of the coating segment, i.e. the sum of the average thicknesses of the lower, middle, and upper layers is in a range of 3.5 µm to 6.0 µm.

An average thickness of the coating segment falling in this range leads to a more reliable increase in the wear resistance and a reduction in separation of the coating segment.

It is even more preferable that the difference between the average thicknesses of the lower, middle, and upper layers should be within ±20%. In other words, if the respective average thicknesses of the lower, middle, and upper layers are approximately equal, the durability is further improved.

In other words, it is even more preferable that the sum of the average thicknesses of the lower, middle and upper layers be in a range of 3.5 µm to 6.0 µm, and each average thickness of the lower, middle, and upper layers be in a range of 1.2 µm to 3.0 µm each.

### (2) Lower layer

The lower layer is provided to improve adhesion between the substrate and the middle layer.

The lower layer preferably includes crystal grains with a face-centered cubic lattice structure (face-centered cubic structure, fcc structure) and comprises composite nitride having an average composition represented by AlₐCr_{b}ML_{1-a-b}N where ML is at least one element selected from the group consisting of Ti, Zr, Hf, V, Nb, Ta, Mo, and W, 0.60 ≤ a ≤ 0.70, and 0.30 ≤ b ≤ 0.40, where a and b are atomic ratios.

The ML component is not essential. If it is included, the atomic ratio should preferably be less than 0.10.

Such average composition can improve the adhesion between the substrate and the middle layer.

In accordance with one exemplary method of production described below, the lower layer is deposited such that the ratio of AlₐCr_{b}ML_{1-a-b} to N, i.e. the ratio of the metal components to nitrogen is 1:1. However, this ratio is not always 1:1. This is also the case for other composite nitrides.

### (3) Middle layer

The middle layer is provided above the lower layer and has an alternating laminate structure with first sublayers and second sublayers. The first and second sublayers should each have an average thickness in a range of 5 nm to 100 nm.

First and second sublayers with this average thickness adhere well to each other. If this range of the average thickness is satisfied, the respective average thicknesses of the first and second sublayers may be the same or different.

The middle layer should preferably have an average thickness in a range of 1.2 µm to 3.0 µm in order to maintain the overall adhesion of the coating segment and to increase its durability.

In the middle layer, either the first sublayer or second sublayer may be in contact with the lower layer. Similarly, either the first sublayer or second sublayer may be in contact with the upper layer. The number of first and second sublayers may be the same, or one may have one more sublayer than the other.

The first and second sublayers both comprise composite nitride of Al-containing crystal grains with a face-centered cubic lattice structure.

The first sublayer has an average composition represented by Al_{c}Ti_{d}M1_{1-c-d}N where M1 is at least one element selected from the group consisting of Zr, Hf, V, Nb, Ta, Mo, and W, 0.50 ≤ c ≤ 0.55, and 0.45 ≤ d ≤ 0.50), while the second sublayer has an average composition represented by AlₑCr_{f}M2_{1-e-f}N where M2 is at least one element selected from the group consisting of Ti, Zr, Hf, V, Nb, Ta, Mo, and W, 0.60 ≤ e ≤ 0.70, and 0.30 ≤ f ≤ 0.40, where c, d, e and f represent atomic ratios.

An atomic ratio c less than e indicates that the Al content of the middle layer is not too high and the microstructure of the middle layer is not too fine.

Both M1 and M2 are not essential. These may however be included to further improve the wear and heat resistance. The upper limits of M1 and M2 in the case of inclusion are 0.50 and 0.10, respectively, in atomic ratio. M1 and M2 are each even more preferably W and/or Mo because their inclusion improves lubricity. In the case that they are included, a total atomic ratio of 0.05 or less is preferred.

Although M1 and M2 are different, M1 and M2 may be the same as ML and MU, respectively, with the proviso that the first and second sublayers can be distinguished as the upper and lower layers.

### (4) Upper layer

The upper layer is provided to enhance the durability of the coating segment in cutting operations especially in milling operations of work materials made of alloy steels with a hardness range of mild steel to about 40 HRC as the work material.

The upper layer is provided on the middle layer. The upper layer preferably includes crystal grains with a face-centered cubic lattice structure and comprises composite nitride having an average composition represented by Al_{g}CrₕMU_{1-g-h}N where MU is at least one element selected from the group consisting of Ti, Zr, Hf, V, Nb, Ta, Mo, and W, 0.60 ≤ g ≤ 0.70 and 0.30 ≤ h ≤ 0.40, where g and h are atomic ratios.

The MU component is not essential. It may however be contained to further enhance the wear and heat resistance. If contained, an atomic ratio of 0.10 or less is preferred.

### (6) Miscellaneous layers

### (6-1) Optional layer

Although the aforementioned issues can be adequately solved with just the lower, middle and upper layers, a topmost layer can be optionally disposed on the upper layer.

A typical example of the topmost layer is a TiN layer, which has a golden color tone. Thus, the topmost layer can function as, for example, an identification layer to determine whether the coated tool has not been used or has been used, by means of a color change on the surface of the coated tool.

The average thickness of the TiN identification layer may be, for example, in a range of 0.1 to 1.0 µm.

### (6-2) Potential incidental layers

In this embodiment, it is intended that no layer is deposited other than the lower, middle, upper and topmost layers. However, during switching of the type of layer to be deposited, pressure and temperature may unintentionally fluctuate in a deposition furnace and an unintentional layer with a different composition from these layers may be incidentally formed between these layers. This layer is referred to as a potential incidental layer.

### 2. Substrate

### (1) Material

The substrate used in the embodiment may be made of any known material that can achieve the aforementioned purpose. Examples of such material include cemented carbides (WC-based cemented carbides, including those containing Co in addition to WC, and also those to which carbides of Ti, Ta and Nb are added), Cermets (e.g. those with TiC, TiN and TiCN as main components), ceramics (e.g. titanium carbide, silicon carbide, silicon nitride and aluminum nitride, and aluminum oxide), cBN sinters, and diamond sinters.

### (2) Shape

The substrate may have any shape suitable for cutting tools. Examples include shapes of inserts, end mills, and drills.

The average thickness of each layer is determined as follows: A longitudinal section (a plane perpendicular to the surface of the substrate, with the proviso that no microscopic irregularities present on the surface of the substrate) of the coated cutting tool is cut out with a focused ion beam (FIB) system. The thicknesses of the longitudinal section of all the layers are determined at five points every layer with a scanning electron microscope (SEM) or a transmission electron microscope (TEM) at any observation magnification, for example, of 5,000 to 10,000. The observed thicknesses of each layer are averaged. The average composition of each layer are measured as follows: The compositions of each layer are determined at five points and averaged using energy dispersive X-ray analysis (EDS) with an SEM or TEM, Auger Electron Spectroscopy (AES), or an electron probe micro analyzer (EPMA). The crystal structure of each layer is identified from a restricted-field diffraction pattern.

The interface between the surface of the substrate and the coating layer is determined as follows:
For a substrate with a flat surface, such as an insert, the interface between the substrate and a layer directly above the substrate is determined in longitudinal section by elemental mapping observed with the aforementioned equipment. The average line (straight line) of the roughness curve connecting two ends of the observation field at the interface is determined arithmetically. The average line is regarded as the surface of the substrate. For a substrate with a curved surface such as a drill, the diameter of this curved surface is sufficiently large in relation to the thickness of the coating segment. Hence, the area for determining the aforementioned average line can be regarded as a substantial flat surface and the interface between the surface of the base material and the coating segment can be determined, like the substrate with a flat surface.

### 4. Production

The coating segment of the embodiment may be produced, for example, by the following PVD process:
An arc ion plating (AIP) system is purged with nitrogen atmosphere. A target of, for example, AlTiML alloy, depending on the desired composite nitride layer is prepared for the formation of the lower layer; a target of AlTiM1 alloy is prepared for the formation of the first middle sublayer, a target of AlCrM2 alloy is prepared for the formation of the second middle sublayer, and a target of AlTiMU alloy is prepared for the formation of the upper layer. Arc discharges are sequentially generated between these targets and an anode to deposit a lower layer, a middle layer (first and second sublayers), and an upper layer, each having a predetermined average thickness. The topmost layer may be deposited by any known process without restriction.

The description above is supported by the following appendices:
(Appendix 1) A coated cutting tool comprising:
   a substrate and a coating segment disposed on the substrate;
   the coating segment including a lower layer, a middle layer on the lower layer, and an upper layer on the middle layer;
   the lower layer comprising composite nitride comprising crystal grains having a face-centered cubic lattice structure and having an average composition represented by AlₐCr_{b}ML_{1-a-b}N where ML is at least one element selected from the group consisting of Ti, Zr, Hf, V, Nb, Ta, Mo, and W, 0.60 ≤ a ≤ 0.70, and 0.30 ≤ b ≤ 0.40;
   the middle layer comprising an alternating laminate of first sublayers and second sublayers, both sublayers having an average thickness in a range of 5 nm to 100 nm and comprising crystal grains with a face-centered cubic lattice structure;
      the first sublayers each comprising composite nitride having an average composition represented by Al_{c}Ti_{d}M1_{1-c-d}N where M1 is at least one element selected from the group consisting of Zr, Hf, V, Nb, Ta, Mo, and W, 0.50 ≤ c ≤ 0.55, and 0.45 ≤ d ≤ 0.55;
      the second sublayers each comprising composite nitride having an average composition represented by AlₑCr_{f}M2_{1-e-f}N wherein M2 is at least one element selected from the group of Ti, Zr, Hf, V, Nb, Ta, Mo, and W, 0.60 ≤ e ≤ 0.70, and 0.30 ≤ f ≤ 0.40;
   the upper layer comprising composite nitride comprising crystal grains having a face-centered cubic lattice structure and an average composition represented by Al_{g}CrₕMU_{1-g-h}N where MU is at least one selected from the group consisting of Ti, Zr, Hf, V, Nb, Ta, Mo, and W, 0.60 ≤ g ≤ 0.70, and 0.30 ≤ h ≤ 0.40.
(Appendix 2) The coated cutting tool as described in Appendix 1, wherein the sum of the average thicknesses of the lower, middle and upper layers ranges from 3.5 µm to 6.0 µm.
(Appendix 3) The coated cutting tool as described in Appendix 2, wherein the average thickness of each of the lower, middle and upper layers ranges from 1.0 µm to 3.0 µm.
(Appendix 4) The coated cutting tool as described in any one of Appendices 1 to 3, wherein the ML content satisfies the relation: 0.0 ≤ 1-a-b ≤ 0.1.
(Appendix 5) The coated cutting tool of any one of Appendices 1 to 4, wherein the MU content satisfies the relation: 0.0 ≤ 1-g-h ≤ 0.1.
(Appendix 6) The coated cutting tool as described in any one of Appendices 1 to 5, wherein the first and second layers have an equal average thickness.

### Examples

Examples will now be described. These examples should not be construed to limit the invention.

### <Example 1>

Substrates were prepared that were inserts (shape: ISO standard EPNW0603TN-8) of WC-based cemented carbide (composition: 11.5 mass% Co, 0.7 mass% Cr₃C₂, 2.0 mass% TaC, the balance being WC and unavoidable impurities).

Coating segments in Inventive Sample 1 and Comparative Examples 1 to 4 were formed with an arc ion plating system, as described above. The target alloys as deposition sources were installed in the system. The tools were cleaned (bombardment treatment) with Ar ions at a temperature of 500 °C in the arc ion plating system. The pressure in the arc ion plating system was evacuated to 5.0×10⁻³ Pa or lower, and N₂ gas was introduced until the pressure in the furnace reaches 3.2 Pa. A bias voltage of -40 V was then applied to the substrate placed in the furnace and a current was supplied to the target alloys to form the lower, middle, and upper layers, in sequence, on the substrate (some comparative examples have only some of the layers formed). The middle layer was deposited such that the average thickness per layer for each of the first and second sublayers was 10 nm and the number of first sublayers was the same as that of second layers. Table 1 lists the composition and average thickness of each layer of the coating segment.

**Table 1**

| Sample | Lower layer | | Middle layer | | Upper layer | |
|---|---|---|---|---|---|---|
| | Composition (atmic %) | Average thickness (*µ*m) | Composition of first sublayer/second sublayer (atmic %) | Average thickness (µm) | Composition (atmic %) | Average thicknes s (*µ*m) |
| Inventive Sample 1 | Al₆₆Cr₃₄N | 1.0 | Al₅₅Ti₄₅N/Al₆₆Cr₃₄N | 1.0 | Al₆₆Cr₃₄N | 1.0 |
| Comparative Sample 1 | Al₅₅Ti₄₅N | 2.0 | - | - | Al₆₆Cr₃₄N | 1.0 |
| Comparative Sample 2 | Al₆₆Cr₃₄N | 1.0 | - | - | Al₅₅Ti₄₅N | 2.0 |
| Comparative Sample 3 | Al₆₆Cr₃₄N | 1.0 | Al₅₅Ti₄₅N | 1.0 | Al₆₆Cr₃₄N | 1.0 |
| Comparative Sample 4 | - | - | Al₅₅Ti₄₅N/Al₆₆Cr₃₄N | 2. 0 | Al₆₆Cr₃₄N | 1.0 |

The composition and average thickness of each layer in Table 1 were measured as described above. The average thicknesses of the first and second sublayers were measured at five points per layer in an observation area containing five first sublayers and five second sublayers at an observation magnification of 50, 000, and averaged to confirm that the average thickness was 10 nm. The average thicknesses of the lower, middle and upper layers were taken at five points per layer, in an observation area at a magnification of 10,000.

In Table 1, symbol "-" indicates that there was no corresponding case, and Comparative Example 3 indicates that only the first sublayer was deposited. It was confirmed that each layer of Inventive Sample 1 and Comparative Examples 1 to 4 had crystal grains with a face-centered cubic lattice structure.

Cutting evaluations were carried out for Inventive Sample 1 and Comparative Samples 1 to 4 under the following two cutting conditions and the time to reach the tool life (expressed as minutes: min) was measured. In detail, the wear width of the flank surface of the coating segment was measured every 5 minutes at a magnification of 100 with an optical microscope, and tool life was defined by the cutting time until the total cutting length reached 0.30 mm. If the wear width of the flank surface exceeded 0.30 mm at a certain measuring time, the difference between the wear width at the measuring time and the wear width at one measurement time before was proportionally distributed within the measuring time interval (5 minutes) and tool life was defined by the time when the wear width of the flak surface reached exactly 0.30 mm.

Table 2 shows the results of measurement.

### Cutting condition 1

Workpiece material: S50C (18HRC)
Type of machining: milling process
Tool number: ASRS2032-5
Shape of insert: EPNW0603TN-8
Cutting speed: 180 m/min.
Feed per cutting edge: 1.5 mm/tooth
Depth of cut in axial direction: 0.5 mm
Depth of cut in radial direction: 21 mm
Type of cutting: dry cutting

### Cutting condition 2

Workpiece material: NAK80 (40HRC)
Type of machining: milling process
Tool number: ASRS2032-5
Shape of insert: EPNW0603TN-8
Cutting speed: 90 m/min
Feed per cutting edge: 0.8 mm/tooth
Axial depth of cut: 0.5 mm
Depth of cut in radial direction: 22 mm
Type of cutting: dry cutting

**Table 2**

| Sample | Cutting condition 1 (min) | Cutting condition 2 (min) |
|---|---|---|
| Inventive Sample 1 | 149 | 38 |
| Comparative Sample 1 | 76 | 28 |
| Comparative Sample 2 | 133 | 38 |
| Comparative Sample 3 | 118 | 35 |
| Comparative Sample 4 | 128 | 38 |

[0044] Table 2 demonstrates that Inventive Sample 1 has no longer time to the tool life in all cutting tests and thus more durable than any Comparative Samples.

### <Example 2>

[0045] A tool of Inventine Sample 10 was produced where only the target alloys for depositing the first and second sublayers were varied from Inventine Sample 1, and the average thickness of each layer was changed from Inventine Sample 1 and tools of Inventive Samples 11 and 12 were produced with a coating segment containing additional Mo or W in the first sublayers of the middle layer. The deposited coating segments are shown in Table 3 (the measurements of the average composition and average thickness were the same as in Example 1, and the average thickness per layer was 10 nm for each of the first and second sublayers with the same number of sublayers). Cutting tests were then carried out according to Cutting condition 2 of Example 1 and the resulting tool life is shown in Table 4. It should be noted that each of the layers in Inventive Samples 10 to 12 was confirmed to have grains with a face-centered cubic lattice structure.

**Table 3**

| Sample | Lower layer | | Middle layer | | Upper layer | |
|---|---|---|---|---|---|---|
| | Composition (atmic %) | Average thickness (*µ*m) | Composition of first sublayer/second sublayer (atmic %) | Average thickness (*µ*m) | Composition (atmic %) | Average thickness (*µ*m) |
| Inventive Sample 10 | Al₆₆Cr₃₄N | 1. 3 | Al₅₅Ti₄₅N/Al₆₆Cr₃₄N | 1. 3 | Al₆₆Cr₃₄N | 1.3 |
| Inventive Sample 11 | Al₆₆Cr₃₄N | 1. 3 | Al₅₄Ti₄₅Mo₁N/Al₆₆Cr₃₄N | 1. 3 | Al₆₆Cr₃₄N | 1.3 |
| Inventive Sample 12 | Al₆₆Cr₃₄N | 1. 3 | Al₅₄Ti₄₅W₁N/Al₆₆Cr₃₄N | 1. 3 | Al₆₆Cr₃₄N | 1.3 |

**Table 4**

| Sample | Cutting condition 2 (min) |
|---|---|
| Inventive Sample 10 | 44 |
| Inventive Sample 11 | 44 |
| Inventive Sample 12 | 47 |

Table 4 evidentially shows that Inventive Samples 10 to 12, where the first sublayers of the middle layer contains Mo and W, have a longer tool life and improved durability than Inventive Sample 1.

### <Example 3>

A tool of Inventive Sample 20 was produced where the same base material as in Inventive Sample 1 was used and the thickness of each layer was increased compared to the thickness of Inventive Sample 1 in Example 1, whereas tools of Comparative Samples (the methods of measuring the average composition and average thickness were the same as in Example 1, and the same number of first and second sublayers each with an average thickness per layer was 10 nm) were prepared where the coating segment had a thickness corresponding to the increased thickness in Inventive Sample 20. A cutting test under Cutting condition 1 was performed on each of Inventive Sample 20 and Comparative Samples 20 to 27 to determine the tool life. The structures of the coating segments of Inventive Sample 20 and Comparative Samples 20 to 27 are shown in Table 5 and the results of the cutting test (tool life) are shown in Table 6. It has been confirmed that the layers of Inventive Sample 20 and Comparative Samples 20 to 27 have a face-centered cubic lattice structure of crystal grains.

**Table 5**

| Sample | Lower layer | | Middle layer | | Upper layer | |
|---|---|---|---|---|---|---|
| | Composition | Average thickness | Composition of first sublayer/second sublayer | Average thickness | Composition | Average thickness |
| | (atmic %) | (*µm*) | (atm ic %) | (*µm*) | (atm i c %) | (*µ*m) |
| Inventive Sample 20 | Al₆₆Cr₃₄N | 1.6 | Al₅₄Ti₄₅Mo₁N/Al₆₆Cr₃₄N | 1.6 | Al₆₆Cr₃₄N | 1.6 |
| Comparative Sample 20 | Al₆₆Cr₃₄N | 2. 5 | Al₅₄Ti₄₅Mo₁N/Al₆₆Cr₃₄N | 2. 5 | - | - |
| Comparative Sample 21 | - | - | Al₅₄Ti₄₅Mo₁N/Al₆₆Cr₃₄N | 2. 5 | Al₆₆Cr₃₄N | 2. 5 |
| Comparative Sample 22 | Stack of Al₅₄Ti₄₅Mo₁N/Al₆₆Cr₃₄N (5.0*µ*m) | | | | | |
| Comparative Sample 23 | Al₅₄Ti₄₅Mo₁N singly layer (5.0*µ*m) | | | | | |
| Comparative Sample 24 | Al₆₆Cr₃₄N | 1.6 | Al₅₄Ti₄₅Mo₁N/Al₆₆Cr₃₄N | 1.6 | Al₅₄Ti₄₅Mo₁N | 1.6 |
| Comparative Sample 25 | Al₅₄Ti₄₅Mo₁N | 1.6 | Al₅₄Ti₄₅Mo₁N/Al₆₆Cr₃₄N | 1.6 | Al₆₆Cr₃₄N | 1.6 |
| Comparative Sample 26 | Al_{42.5}Ti_{42.5}W₁₅N | 3.0 | - | - | Al₆₆Cr₃₄N | 1.5 |
| Comparative Sample 27 | Al_{42.5}Ti_{42.5}W₁₅N | 5.0 | - | - | Al₆₆Cr₃₄N | 1.0 |

In Table 5, symbol '-' indicates that there was no corresponding case, and Comparative Examples 22 and 23 indicate that only the layers shown in Table 5 were deposited.

**Table 6**

| Sample | Cutting condition 1 (min) |
|---|---|
| Inventive Sample 20 | 244 |
| Comparative Sample 20 | 211 |
| Comparative Sample 21 | 223 |
| Comparative Sample 22 | 199 |
| Comparative Sample 23 | 150 |
| Comparative Sample 24 | 133 |
| Comparative Sample 25 | 151 |
| Comparative Sample 26 | 77 |
| Comparative Sample 27 | 77 |

Table 6 demonstrate that Inventive Sample 20 with a thicker coating segment compared to Inventive Sample 1 has a longer tool life than Inventive Sample 1, and than Comparative Samples 20 to 27 with the same or thicker coating segment than that of Inventive Sample 20.

In conclusion, the results of Examples 1 to 3 confirm that Inventive Samples are more durable and have longer lives than Comparative Samples. It is presumed that the structure of the coating segment of the present invention with an AlCrN system in the lower layer and alternating sublayers of AlTiN and AlCrN systems in the middle layer and an AlCrN system in the upper layer has improved tool life compared to other structures of the coating segment because of its excellent adhesion, high chipping resistance, and high welding resistance.

The disclosed embodiments are in all respects illustrative only and not restrictive. The scope of the invention is indicated by the claims rather than the aforementioned embodiments and is intended to include all modifications within the gist and scope of the claims and equivalents.

### Reference Numerals

- 1: substrate
- 2: under layer
- 3: middle layer
- 4: upper layer
- 5: first sublayer
- 6: second sublayer

## Claims

1. A coated cutting tool comprising:
a substrate and a coating segment disposed on the substrate;
the coating segment including a lower layer, a middle layer on the lower layer, and an upper layer on the middle layer;
the lower layer comprising composite nitride comprising crystal grains having a face-centered cubic lattice structure and having an average composition represented by AlₐCr_{b}ML_{1-a-b}N where ML is at least one element selected from the group consisting of Ti, Zr, Hf, V, Nb, Ta, Mo, and W, 0.60 ≤ a ≤ 0.70, and 0.30 ≤ b ≤ 0.40;
the middle layer comprising an alternating laminate of first sublayers and second sublayers, both sublayers having an average thickness in a range of 5 nm to 100 nm and comprising crystal grains with a face-centered cubic lattice structure;
the first sublayers each comprising composite nitride having an average composition represented by Al_{c}Ti_{d}M1_{1-c-d}N where M1 is at least one element selected from the group consisting of Zr, Hf, V, Nb, Ta, Mo, and W, 0.50 ≤ c ≤ 0.55, and 0.45 ≤ d ≤ 0.55;
the second sublayers each comprising composite nitride having an average composition represented by AlₑCr_{f}M2_{1-e-f}N wherein M2 is at least one element selected from the group of Ti, Zr, Hf, V, Nb, Ta, Mo, and W, 0.60 ≤ e ≤ 0.70, and 0.30 ≤ f ≤ 0.40;
the upper layer comprising composite nitride comprising crystal grains having a face-centered cubic lattice structure and an average composition represented by Al_{g}CrₕMU_{1-g-h}N where MU is at least one selected from the group consisting of Ti, Zr, Hf, V, Nb, Ta, Mo, and W, 0.60 ≤ g ≤ 0.70, and 0.30 ≤ h ≤ 0.40.

2. The coated cutting tool as claimed in claim 1, wherein the sum of the average thicknesses of the lower, middle and upper layers ranges from 3.5 µm to 6.0 µm.
